# EUROPEAN PATENT APPLICATION

(11) **EP 4 814 501 A1**
(43) Date of publication of application: **30.09.2026**
(21) Application number: 26165846.2
(22) Date of filing: 18.03.2026
(51) Int. Cl.: G01R 19/00, H03F 1/26, H03F 3/08, H03F 3/45, G06F 119/10

(54) **OPTIMIZED NOISE SUPPRESION FOR ENHANCED SIGNAL PROCESSING**

(30) Priority: 25.03.2025 US 202519090361
(71) Applicant: Avago Technologies International Sales Pte. Limited, Singapore 768923 (SG)
(72) Inventor: BRENKUS, Juraj, 1120 Vienna (AT); GABERL, Wolfgang, 1120 Vienna (AT); DAVIDOVIC, Milos, 1120 Vienna (AT)
(74) Representative: Dilg, Haeusler, Schindelmann Patentanwaltsgesellschaft mbH

(57) **Abstract**

An integrated circuit (IC) may be configured to receive and process input signals with respect to a first ground that is coupled to a second ground. The input signals may be referenced to the second ground. The IC may be configured to receive, by the first input terminal and by a second input terminal of the IC that is coupled to the second ground, noise signals. The IC may be configured to route the input signals and the noise signals from the first input terminal to a first differential input terminal of a differential signal converter of the IC and the noise signals from the second input terminal to a second differential input terminal of the differential signal converter while maintaining symmetry between an input impedance toward the first differential input terminal and an input impedance toward the second differential input terminal.

## Description

### BACKGROUND

Systems may utilize circuitry to acquire and process signals. For example, data processing systems may use circuitry to acquire signals, condition the signals to enhance signal quality, and convert the signals into a suitable format for analysis. The data processing system may analyze the processed signals using computational techniques to extract relevant information.

### SUMMARY

Some implementations described herein relate to an integrated circuit, comprising: a first ground coupled to a second ground; a first input terminal configured to: receive input signals referenced to the second ground, and receive noise signals coupled through the second ground, wherein the integrated circuit is configured to process the input signals and the noise signals with respect to the first ground; a second input terminal, coupled to the second ground, configured to receive the noise signals coupled through the second ground; a differential signal converter including a first differential input terminal and a second differential input terminal; and circuitry configured to: route the input signals and the noise signals from the first input terminal to the first differential input terminal; and route the noise signals from the second input terminal to the second differential input terminal while maintaining symmetry between an input impedance toward the first differential input terminal and an input impedance toward the second differential input terminal.

Some implementations described herein relate to a system, comprising: an input source configured to generate input signals; and an integrated circuit configured to process the input signals with respect to a first ground, wherein the input signals are referenced to a second ground that is coupled to the first ground, the integrated circuit including: a first input terminal configured to: receive the input signals from the input source; and receive noise signals coupled through the second ground; a second input terminal, coupled to the second ground, configured to receive the noise signals coupled through the second ground; and circuitry, including a differential signal converter having a first differential input terminal and a second differential input terminal, configured to: route the input signals and the noise signals from the first input terminal to the first differential input terminal; and route the noise signals from the second input terminal to the second differential input terminal while maintaining symmetry between an input impedance toward the first differential input terminal and an input impedance toward the second differential input terminal.

Some implementations described herein relate to a method, comprising: receiving input signals, by a first input terminal of an integrated circuit configured to process the input signals with respect to a first ground that is coupled to a second ground, wherein the input signals are referenced to the second ground that is coupled to the first ground; receiving, by the first input terminal and by a second input terminal of the integrated circuit that is coupled to the second ground, noise signals; routing the input signals and the noise signals to a first differential input terminal of a differential signal converter of the integrated circuit; and routing the noise signals from the second input terminal to a second differential input terminal of the differential signal converter while maintaining symmetry between an input impedance toward the first differential input terminal and an input impedance toward the second differential input terminal.

### BRIEF DESCRIPTION OF THE DRAWINGS

Fig. 1 is a diagram of an example implementation associated with optimized noise suppression for enhanced signal processing.
Fig. 2 is a diagram of an example signal processing system associated with optimized noise suppression for enhanced signal processing.
Fig. 3 is a diagram of an example current conveyor stage and an example integration stage of a circuit associated with optimized noise suppression for enhanced signal processing.
Fig. 4 is a diagram of an example differential current conveyor circuit associated with optimized noise suppression for enhanced signal processing.
Fig. 5 is a diagram of an example additive current conveyor circuit associated with optimized noise suppression for enhanced signal processing.
Fig. 6 is diagram of an example signal processing system associated with optimized noise suppression for enhanced signal processing.
Fig. 7 is a flowchart of an example process associated with optimized noise suppression for enhanced signal processing.

### DETAILED DESCRIPTION

The following detailed description of example implementations refers to the accompanying drawings. The same reference numbers in different drawings may identify the same or similar elements.

Signals, such as electrical signals, may be referenced to a ground, and a system may be configured to process the signals relative to a different ground. However, processing the signals relative to the different ground introduces challenges. For example, currents generated within the system may interact with parasitic inductances of the system (e.g., parasitic inductances within a package, such as parasitic inductances from one or more ICs to a pad of the package caused by one or more bonding wires, among other examples), leading to unwanted voltage fluctuations and introducing noise, such as ground bounce, into the system.

In systems using integrated circuits (ICs) referenced to a first ground for signal processing, ground bounce typically arises from asynchronous operation of the ICs relative to a timing of the input signals, which are referenced to a second ground that is different from the first ground. This occurs when currents (e.g., dynamic currents) are generated asynchronously with respect to a timing of the input signals. These currents, when coupled with the parasitic inductances of the system, may cause voltage shifts between the first ground of the ICs and the second ground. This shift in ground potential generates noise signals, which may also be referred to herein as ground bounce, which are received at an input of the system (e.g., the noise signals are coupled through the second ground), which are then processed by the ICs.

For example, the ICs may include a front-end IC, an evaluation IC, and/or additional circuitry (e.g., processing circuitry and/or voltage converters, among other examples) referenced to a first ground for signal processing. The front-end IC may be configured to receive and process the signals (e.g., in an input stage), which are referenced to a second ground, before providing the signals to the evaluation IC for further processing (e.g., in an evaluation stage). When the potentials created by the ICs are referenced to the first ground, the second ground may exhibit signal spikes or bounces. These signal spikes or bounces propagate through the front-end IC and reach the evaluation IC, compromising the integrity of the signals processed by the ICs (e.g., the front-end IC and the evaluation IC), which can lead to distorted measurements or false event detection, among other examples.

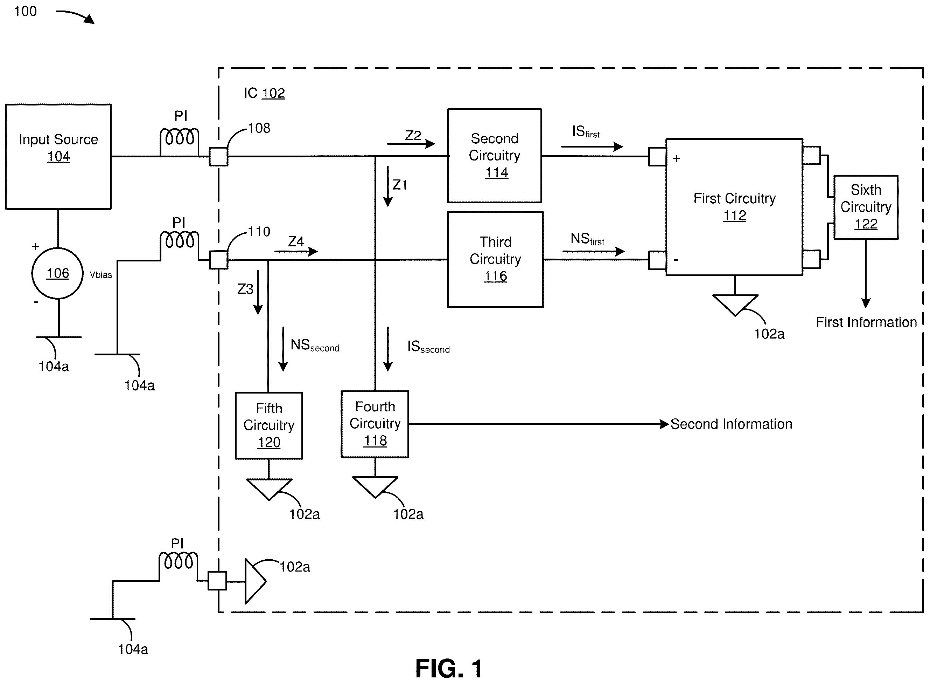

Fig. 1 is a diagram of an example implementation 100 associated with optimized noise suppression (e.g., optimized ground bounce suppression) for enhanced signal processing. As shown in Fig. 1, the implementation 100 includes an IC 102 (e.g., having a first ground 102a) coupled to an input source 104 (e.g., having a second ground 104a). In some implementations, the first ground 102a may be coupled to the second ground 104a.

The IC 102 may include a first input terminal 108 configured to receive input signals referenced to the second ground 104a. The first input terminal 108 may be further configured to receive noise signals coupled through the second ground 104a. The IC 102 may be configured to process the input signals and the noise signals with respect to the first ground 102a.

The IC 102 may further include a second input terminal 110 that is coupled to the second ground 104a. The second input terminal 110 may be configured to receive the noise signals coupled through the second ground 104a. The IC 102 may include circuitry (e.g., shown as first circuitry 112, second circuitry 114, third circuitry 116, fourth circuitry 118, fifth circuitry 120, and sixth circuitry 122 in Fig. 1, as described in more detail elsewhere herein). In some implementations, the circuitry may include a differential signal converter (e.g., a differential transimpedance amplifier, among other examples) having a first differential input terminal and a second differential input terminal.

In some implementations, the circuitry of the IC 102 may be configured to route the input signals and the noise signals from the first input terminal 108 to the first differential input terminal (e.g., of the differential signal converter), and route the noise signals from the second input terminal 110 to the second differential input terminal (e.g., of the differential signal converter) while maintaining symmetry between an input impedance toward the first differential input terminal and an input impedance toward the second differential input terminal.

In some implementations, the differential signal converter may be configured to convert the input signals into converted signals and suppress the noise signals via common-mode rejection. In some implementations, the circuitry of the IC 102 may be further configured to detect, based on the converted signals, measurement values corresponding to physical quantities associated with detected events.

In some implementations, the circuitry of the IC 102 may be further configured to pass frequency components of the input signals and first frequency components of the noise signals in a first bandwidth from the first input terminal 108 to the first differential input terminal, pass second frequency components of the noise signals in the first bandwidth from the second input terminal 214 to the second differential input terminal, and/or extract frequency components from the input signals in a second bandwidth associated with frequencies that are lower than frequencies associated with the first bandwidth maintaining the symmetry between the input impedance toward the first differential input terminal and the input impedance toward the second differential input terminal.

In some implementations, the differential signal converter may be further configured to convert the frequency components of the input signals in the first bandwidth into converted signals and suppress the noise signals by rejecting the first frequency components of the noise signals and the second frequency components of the noise signals in the first bandwidth. In some implementations, the first bandwidth may correspond to frequencies associated with a first signal information type and the second bandwidth may correspond to frequencies associated with a second signal information type. In some implementations, the input signals may be received from different input sources (e.g., different sensors). In some implementations, the circuitry of the IC 102 may be further configured to produce currents inducing differences in potentials between the first ground and the second ground resulting in generation of the noise signals.

In some implementations, the input source 104 may be associated with a time-of-flight (TOF)-based system and/or a system utilizing TOF principles. For example, the input source 104 may be associated with a light detection and ranging (LIDAR) system, a TOF-positron emission tomography (TOF-PET) system, a TOF-based flow cytometry system, a TOF radiation detection system, a TOF-computed tomography (TOF-CT) system (e.g., an X-ray photon counting system), and/or a TOF-based life sciences signal processing system, among other examples. Although the input source 104 is described as being associated with a TOF-based system and/or a system utilizing TOF principles, the input source 104 may be associated with any suitable system where optimization of ground bounce suppression for enhanced signal processing is useful.

In some implementations, the input source 104 may be configured to be powered by a power supply (e.g., shown as a power supply 106 in Fig. 1) that is coupled to a substrate, such as a circuit board, having a second ground 104a that is coupled to the first ground 102a. The input source 104 may be configured to generate input signals referenced to the second ground 104a. The IC 102 may be configured to process the input signals with respect to the first ground 102a, as described in more detail elsewhere herein.

In some implementations, the input signals may correspond to physical quantities associated with events, such as system-specific events. For example, the input signals may represent reflected laser pulses in a LIDAR system, representing detected reflections from a target object; electrical signals in a TOF-PET system, indicating a detection of a photon (e.g., a gamma photon); fluorescence signals in a flow cytometry system, associated with light emitted by fluorescently-labeled particles; radiation signals in a radiation detection system, representing detected radiation events from a radioactive source; X-ray photon signals in a TOF-CT system, corresponding to detected X-ray photons; biological signals in a life sciences system, associated with at least one of emitted fluorescence or light scattering from a biological sample; and/or electrical signals in a power system, indicating detected changes in at least one of voltage or current, among other examples.

In some implementations, the IC 102 may be configured to interface with the input source 104 to receive the input signals for processing. For example, the IC 102 may include a first input terminal 108 coupled to the input source 104. The IC 102 may be configured to receive the input signals (e.g., from the input source 104 and referenced to the second ground 104a) and process the input signals with respect to the first ground 102a, as described in more detail elsewhere herein.

In some implementations, the IC 102 may be coupled to the input source 104 and/or to the second ground 104a via conductive elements, such as leads, traces, vias, interfaces, ground couplings, and/or bonding wires. These conductive elements may exhibit parasitic inductance (e.g., shown as PI in Fig. 1), which can lead to voltage fluctuations between the first ground 102a and the second ground 104a that generate noise signals (e.g., ground bounce), as described in more detail elsewhere herein.

In some implementations, the IC 102 may include circuitry configured to produce currents, such as dynamic or time-varying currents that are asynchronous relative to a timing of when the first input terminal 108 receives the input signal. For example, the circuitry of the IC 102 may be configured to produce the dynamic or time-varying currents based on transistor switching, signal transitions, and/or internal processing activity of the circuitry, among other examples. In other words, the IC 102 may include circuitry (e.g., producing the currents) configured to operate independently of the timing when the first input terminal 108 receives the input signals. These currents may interact with the parasitic inductances, inducing voltage drops across the parasitic inductances. This interaction can cause potential differences between the first ground 102a and the second ground 104a, leading to generation of noise signals (e.g., ground bounce).

In some implementations, the noise signals, received at the first input terminal 108 and the second input terminal 110, may have matching signal characteristics (e.g., matching magnitudes, phases, and/or timing characteristics, among other examples). In some implementations, the IC 102 may include circuitry (e.g., shown as first circuitry 112, second circuitry 114, third circuitry 116, fourth circuitry 118, fifth circuitry 120, and sixth circuitry 122 in Fig 1). The first circuitry 112 may include differential processing circuitry, such as a differential signal converter (e.g., a differential transimpedance amplifier (TIA), among other examples) including a first differential input terminal (e.g., shown as a non-inverting input terminal in Fig. 1) and a second differential input terminal (e.g., shown as an inverting input terminal in Fig. 1).

The second circuitry 114 may be configured to pass frequency components of the input signals and first frequency components of the noise signals (e.g., received at the first input terminal 108) in a first bandwidth (e.g., shown as a current signal IS_{first} in Fig. 1) to the first differential input terminal. For example, the second circuitry 114 may include a coupling element (e.g., an alternating current (AC)-coupling capacitor, among other examples) configured to pass the frequency components of the input signals and the first frequency components of the noise signals in the first bandwidth to the first differential input terminal.

The third circuitry 116 may be configured to couple the second differential input terminal to the second input terminal 110. In some implementations, the third circuitry 116 may be configured to pass second frequency components of the noise signals (e.g., received at the second input terminal 110) in the first bandwidth (e.g., shown as a current signal NS_{first} in Fig. 1) to the second differential input terminal. For example, the third circuitry 116 may include a coupling element (e.g., an AC-coupling capacitor, among other examples) configured to pass the second frequency components of the noise signals in the first bandwidth to the second differential input terminal.

In some implementations, a lower cut-off frequency of the first bandwidth may be based on capacitance values of the coupling elements (e.g., capacitance values of the AC-coupling capacitor included in the second circuitry 114 and the AC-coupling capacitor included in the third circuitry 116, among other examples), and an upper cut-off frequency of the first bandwidth may be based on a bandwidth of the differential signal converter included in the first circuitry 112 and/or parasitic inductances that affect operation of the differential signal converter included in the first circuitry 112, among other examples.

In some implementations, the fourth circuitry 118 may be coupled to the first input terminal 108, such as in a parallel configuration relative to the second circuitry 114, and may be referenced to the first ground of the IC 102. For example, and as shown in Fig. 1, the fourth circuitry 118 may be coupled between the first input terminal 108 and the second circuitry 114 (e.g., the fourth circuitry 118 may be coupled between the first input terminal 108 and the AC-coupling capacitor included in the second circuitry 114). An input impedance of the fourth circuitry 118 (e.g., shown as Z1 in Fig. 1) may affect an input impedance toward the first differential input terminal (e.g., shown as Z2 in Fig. 1).

In some implementations, the fourth circuitry 118 may be configured to extract frequency components from the input signals in a second bandwidth associated with lower frequencies than frequencies associated with the first bandwidth (e.g., shown as a current signal IS_{second} in Fig. 1). Accordingly, the first bandwidth may correspond to frequency components that satisfy a first threshold (e.g., a first threshold of at least 100 megahertz (MHz)) and may be associated with a first signal information type, such as timing signal information, and the second bandwidth may correspond to frequency components that satisfy a second threshold (e.g., a lower threshold of at least 10 MHz and an upper threshold of 30 MHz or less) and may be associated with a second signal information type, such as energy signal information, as described in more detail elsewhere herein. In this way, the first bandwidth and the second bandwidth may be selected based on an application associated with the implementation 100. In some implementations, a frequency range of the second bandwidth may be selected based on the input impedance of the of the fourth circuitry 118 relative to the input impedance toward the first differential input terminal (e.g., an equivalent input impedance of Z1 relative to Z2).

As further shown in Fig. 1, the fifth circuitry 120 may be coupled to the second input terminal 110 in a parallel configuration relative to the third circuitry 116. For example, the fifth circuitry 120 may be coupled between the second input terminal 110 and the third circuitry 116. In some implementations, the fifth circuitry 120 may be configured to maintain an input impedance (e.g., shown as Z3 in Fig. 1) that matches the input impedance of the fourth circuitry (e.g., Z1).

In this way, the input impedance toward the second differential input terminal (e.g., shown as Z4 in Fig. 1 matches the input impedance toward the first differential input terminal. Accordingly, the first differential input terminal and the second differential input terminal may be configured to exhibit a same, or a similar, frequency response during operation, which, in turn, preserves balance and performance of the operation of the differential signal converter included in the first circuitry 112.

In some implementations, the fourth circuitry 118 and the fifth circuitry 120 may be matching circuits; however, the fifth circuitry 120 may include any suitable electrical components configured to maintain the input impedance that matches the input impedance of the fourth circuitry 118. For example, the fifth circuitry 120 may be configured to extract frequency components from the noise signals in the second bandwidth (e.g., shown as a current NS_{second} in Fig. 1) to maintain, or substantially maintain, the same input impedance as the fourth circuitry 118.

Accordingly, and in some implementations, the input signals received at the first input terminal 108 may be proportional to the physical quantities associated with the detected events, may include the physical quantities with the noise signals superimposed, or may correspond to the noise signals. Although the input signals received at the first input terminal 108 may be proportional to the physical quantities associated with the detected events, may include the physical quantities with the noise signals superimposed, or may correspond to the noise signals, the differential signal converter (e.g., included in the first circuitry 112) may be configured to convert frequency components of input signals that are proportional to the physical quantities associated with the events within the first bandwidth to converted signals while rejecting the first frequency components and the second frequency components of the noise signals in the first bandwidth.

Accordingly, and in some implementations, a differential (e.g., a fully differential or substantially differential) and symmetrical, or substantially symmetrical, configuration may be configured to provide the input signals to the differential signal converter as referenced to the second ground 104a, rendering any noise signals (e.g., ground bounce) generated (e.g., in association with processing performed by the IC 102) negligible, or substantially negligible, in the differential output signals provided by the differential signal converter.

In some implementations, the sixth circuitry 122 may be configured to determine, based on the converted signals, first information (e.g., timing information) and the fourth circuitry 118 may be configured to determine, based on the second frequency components of the input signals in the second bandwidth, second information (e.g., energy information), as described in more detail elsewhere herein.

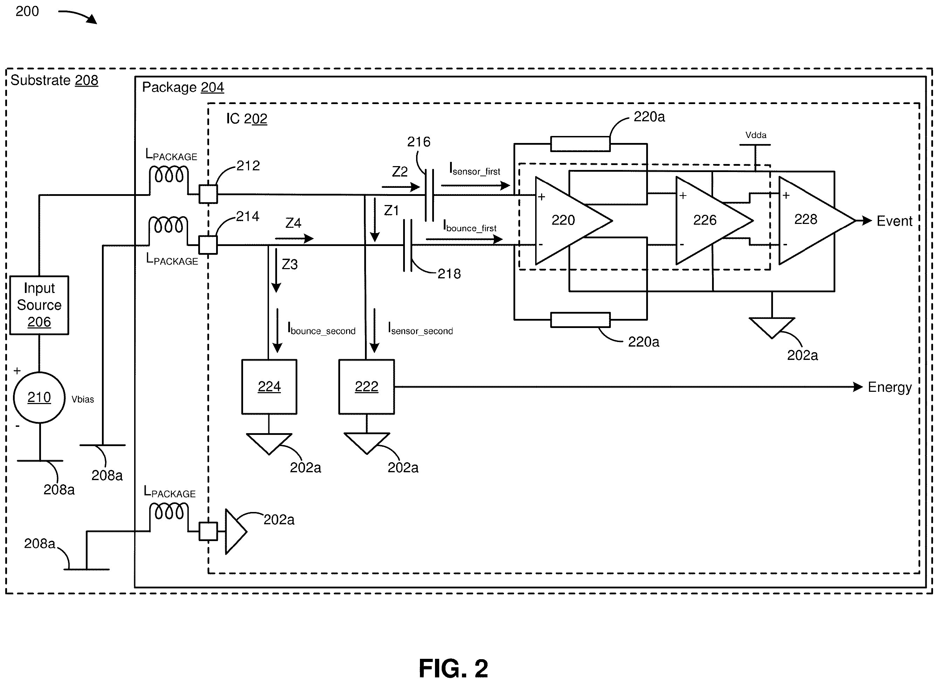

Fig. 2 is a diagram of an example signal processing system 200 associated with optimized noise suppression for enhanced signal processing, as described herein. In some implementations, the signal processing system may be a TOF-based system (e.g., a TOF-based data acquisition and processing system) associated with optimized noise suppression (e.g., optimized ground bounce suppression) for enhanced signal processing (e.g., enhanced timing and energy signal evaluation), as described in more detail elsewhere herein.

As shown in Fig. 2, the signal processing system 200 may include an IC 202 having a first ground 202a (e.g., which may correspond to the IC 102), a package 204 (e.g., encapsulating the IC 202), an input source 206 (e.g., which may correspond to the input source 104), and a substrate 208 (e.g., a printed circuit board (PCB)) having a second ground 208a (e.g., a PCB ground, among other examples).

In some implementations, the input source 206 may be an optical sensor, such as a silicon photomultiplier (SiPM) configured to detect photons (e.g., photon events) and generate output signals (e.g., current signals) that are proportional to a photon flux of the detected photons (e.g., the detected photon events). For example, the current signals may represent electrical signals in a TOF-PET system, indicating a detection of a photon (e.g., a gamma photon), as described in more detail elsewhere herein.

Although the current signals are described as representing the electrical signals in the TOF-PET system, the current signals may represent any suitable electrical signals, such as reflected laser pulses in a LIDAR system, indicating detected reflections from a target object; fluorescence signals in a flow cytometry system, associated with light emitted by fluorescently-labeled particles; radiation signals in a radiation detection system, corresponding to detected radiation events from a radioactive source; X-ray photon signals in a TOF-CT system, linked to detected X-ray photons; biological signals in a life sciences system, corresponding to emitted fluorescence or light scattering from a biological sample; and/or electrical signals in a power system, indicating detected changes in voltage or current, among other examples.

In some implementations, the SiPM may include multiple single-photon avalanche diodes (SPADs), which are semiconductor devices configured to detect individual photons. For example, the SPADs may be configured to generate a current pulse in response to a photon interacting with photosensitive areas of the SPADs.

In some implementations, the SPADs may be configured to be biased above breakdown voltages of the SPADs, allowing a single photon to trigger an avalanche when the photon contacts the photosensitive areas. For example, the SiPM may be powered by a power supply (e.g., shown as a power supply 210 in Fig. 2) configured to bias the SPADs of the SiPM above the breakdown voltages, enabling operation in Geiger mode.

In some implementations and based on the SPADs operating in the Geiger mode, an arrival of a single photon may initiate a self-sustaining avalanche multiplication process within the SPADs. This process may produce a uniform electrical pulse (e.g., a uniform charge pulse), irrespective of whether one photon or multiple photons initiate avalanches in the SPADs. Accordingly, operating the SPADs in Geiger mode enables single-photon detection, with each triggered SPAD producing a uniform electrical pulse.

Multiple simultaneous photon events may be summed across different SPADs, resulting in an output signal that is proportional to the photon flux. Thus, the SPADs may be configured to generate current pulses corresponding to individual photon detection events. In some implementations, the input source 206 may be coupled to the second ground 208a (e.g., an anode or a cathode of the SiPM may be coupled to the second ground 208a). In this way, the input source 206 may be configured to generate current signals which are referenced to the second ground 208a. The input source 206 may be configured to provide these current signals to the IC 202 for processing, as described in more detail elsewhere herein.

In some implementations, the first ground 202a may be coupled to the second ground 208a. The input source 206 may be configured to generate input signals referenced to the second ground 208a. The IC 202 may be configured to process the input signals with respect to the first ground 202a. In some implementations, the IC 202 may include a first input terminal 212 that interfaces with the input source 206. The first input terminal 212 may be configured to receive the input signals from the input source 206.

In some implementations, one or more components of the IC 202, the package 204, the input source 206, and/or the substrate 208 may be coupled to one another via conductive elements (e.g., interconnections), such as leads, traces, vias, interfaces, ground couplings, and/or bonding wires. These conductive elements may exhibit parasitic inductance (e.g., shown as L_{PACKAGE} in Fig. 2), which can lead to voltage fluctuations between the first ground 202a and the second ground 208a that generate noise signals (e.g., ground bounce), as described in more detail elsewhere herein.

In some implementations, the IC 202 may include circuitry configured to produce currents, such as dynamic or time-varying currents that are asynchronous relative to a timing of when the first input terminal 212 receives the input signals. For example, the circuitry of the IC 202 may be configured to produce the dynamic or time-varying currents based on transistor switching, signal transitions, and/or internal processing activity of the circuitry, among other examples. In other words, the IC 202 may include circuitry (e.g., producing the currents) configured to operate independently of the timing when the first input terminal 212 receives the input signals. These currents may interact with the parasitic inductances, inducing voltage drops across the parasitic inductances. This interaction can cause potential differences between the first ground 202a and the second ground 208a, leading to generation of noise signals (e.g., ground bounce).

In some implementations, the first input terminal 212 may be further configured to receive the noise signals coupled through the second ground 208a (e.g., based on the differences in potential between the first ground 202a and the second ground 208a). In some implementations, the IC 202 may include a second input terminal 214 that is coupled to the second ground 208a. The second input terminal 214 may be configured to receive the noise signals coupled through the second ground 208a (e.g., based on the difference in potential between the first ground 202a and the second ground 208a).

In some implementations, the circuitry of the IC 202 may further include a first AC-coupling capacitor 216, a second AC-coupling capacitor 218, and a differential transimpedance amplifier (TIA) 220 having a differential input (e.g., shown as including a first differential input terminal, or a non-inverting input terminal, and a second differential input terminal, or an inverting input terminal in Fig. 2) and a differential output. The first AC-coupling capacitor 216 may be configured to AC-couple the first differential input terminal to the first input terminal 212 and the second AC-coupling capacitor 218 may be configured to AC-couple the second differential input terminal to the second input terminal 214, as described in more detail elsewhere herein.

In some implementations, the circuitry of the IC 202 may be configured to route the input signals and the noise signals from the first input terminal 212 to the first differential input terminal and route the noise signals from the second input terminal 214 to the second differential input terminal while maintaining symmetry between an input impedance toward the first differential input terminal and an input impedance toward the second differential input terminal.

In some implementations, the differential TIA 220 may be further configured to convert the input signals into converted signals and suppress the noise signals via common-mode rejection. In some implementations, the circuitry of the IC 202 may be further configured to pass frequency components of the input signals and first frequency components of the noise signals in a first bandwidth to the first differential input terminal, pass second frequency components of the noise signals in the first bandwidth to the second differential input terminal, and/or extract frequency components from the input signals in a second bandwidth associated with frequencies that are lower than frequencies associated with the first bandwidth while maintaining the symmetry between the input impedance toward the first differential input terminal and the input impedance toward the second differential input terminal.

In some implementations, the differential TIA 220 may be further configured to convert the frequency components of the input signals in the first bandwidth into converted signals corresponding to physical quantities associated with detected events and suppress the noise signals by rejecting the first frequency components of the noise signals and the second frequency components of the noise signals in the first bandwidth.

In some implementations, the noise signals received at the first input terminal 212 and the second input terminal 214 may have matching signal characteristics (e.g., the noise signals received at the first input terminal 212 and the second input terminal 214 may have matching magnitudes, phases, and/or timing characteristics, among other examples).

In some implementations, the circuitry of the IC 202 may further include a signal processing circuit 222 (e.g., a signal conditioning and evaluation circuit), an impedance matching circuit 224, a pre-amplifier 226 (e.g., a pre-amplifier circuit), and a comparator 228 (e.g., a comparator circuit).

In some implementations, the differential TIA 220 may be a single-stage circuit (e.g., a fully differential single-stage circuit) implemented in complementary metal-oxide-semiconductor (CMOS) or bipolar-CMOS (BiCMOS) technologies, utilizing a differential pair topology. For example, the differential TIA 220 may be configured to convert differential input current into differential output voltage while improving common-mode noise rejection and signal integrity, as described in more detail elsewhere herein. Although the differential TIA 220 is shown and described in connection with Fig. 2 as being a single-stage circuit implemented in CMOS or BiCMOS technologies, utilizing a differential pair topology, the differential TIA 220 may be implemented in any suitable manner.

In some implementations, the first AC-coupling capacitor 216 may be configured to pass frequency components of the input signals and first frequency components of the noise signals (e.g., received at the first input terminal 212) in a first bandwidth (e.g., shown as a current signal I_{sensor_first} in Fig. 2) to the first differential input terminal of the differential TIA 220. In some implementations, the second AC-coupling capacitor 218 may be configured to pass frequency components of the noise signals (e.g., received at the second input terminal 214) in the first bandwidth (e.g., shown as a current signal I_{bounce_first} in Fig. 2) to the second differential input terminal of the differential TIA 220.

In some implementations, a lower cut-off frequency of the first bandwidth may be based on capacitance values of the first AC-coupling capacitor 216 and the second AC-coupling capacitor 218, and an upper cut-off frequency of the first bandwidth may be based on a bandwidth of the differential TIA 220 and/or parasitic inductances (e.g., L_{PACKAGE}) that affect operation of the differential TIA 220, among other examples.

In some implementations, the signal processing circuit 222 may be coupled to the first input terminal 212 and may be referenced to the first ground of the IC 202. For example, and as shown in Fig. 2, the signal processing circuit 222 may be coupled between the first input terminal 212 and the first AC-coupling capacitor 216. An input impedance of the signal processing circuit (e.g., shown as Z1 in Fig. 2) may affect an input impedance toward the first differential input terminal of the differential TIA 220 (e.g., shown as Z2 in Fig. 2).

In some implementations, the signal processing circuit 222 may be configured to extract (e.g., via a direct current (DC)-coupling circuit, among other examples) frequency components from the input signals in a second bandwidth (e.g., shown as a current signal I_{sensor_second} in Fig. 2), which may be associated with lower frequencies than frequencies associated with the first bandwidth. Accordingly, the first bandwidth may correspond to frequency components (e.g., of signals conditioned by the first AC-coupling capacitor 216) that satisfy a first threshold (e.g., a first threshold of at least 100 megahertz (MHz)) and may be associated with a first signal information type, such as timing signal information, and the second bandwidth may correspond to frequency components (e.g., of signals conditioned by the signal processing circuit 222) that satisfy a second threshold (e.g., a lower threshold of 0 MHz and an upper threshold of 70 MHz or less, among other examples) and may be associated with a second signal information type, such as energy signal information, as described in more detail elsewhere herein.

In this way, the first bandwidth and the second bandwidth may be selected based on an application, such as a TOF timing and energy evaluation application. In some implementations, a frequency range of the second bandwidth may be selected based on the input impedance of the of the signal processing circuit 222 relative to the input impedance toward the first differential input terminal of the differential TIA 220 (e.g., an equivalent input impedance of the of the signal processing circuit 222, Z1, relative to the input impedance toward the first differential input terminal of the differential TIA 220, Z2).

In some implementations, the frequency components of the input signals in the second bandwidth may be energy frequency components (e.g., in the second bandwidth, as described in more detail elsewhere herein) and the signal processing circuit 222 may include energy evaluation circuitry configured to determine, based on the frequency components of the input signals in the second bandwidth, energy information. For example, the energy evaluation circuitry may include one or more current conveyor circuits and/or one or more integrator circuits configured to determine an energy of photons, as described in more detail elsewhere herein.

As further shown in Fig. 2, the impedance matching circuit 224 may be coupled to the second input terminal 214 and may be referenced to the first ground 202a. For example, and as shown in Fig. 2, the impedance matching circuit 224 may be coupled between the second input terminal 214 and the second AC-coupling capacitor 218. In some implementations, the impedance matching circuit 224 may be configured to maintain an input impedance (e.g., shown as Z3 in Fig. 2) that matches the input impedance of the fourth circuitry (e.g., Z1).

In this way, the input impedance toward the second differential input terminal of the differential TIA 220 (e.g., shown as Z4 in Fig. 2) may match the input impedance toward the first differential input terminal of the differential TIA 220 (e.g., Z2). Accordingly, the first differential input terminal and the second differential input terminal may be configured to exhibit a same, or a similar, frequency response during operation, which, in turn, preserves balance and performance of the operation of the differential TIA 220.

In some implementations, the impedance matching circuit 224 may be configured to match the signal processing circuit 222. For example, the impedance matching circuit 224 may be configured to extract frequency components from the noise signals in the second bandwidth (e.g., shown as a current signal I_{bounce_second} in Fig. 2), to maintain the same input impedance as the signal processing circuit 222.

Although the impedance matching circuit 224 is described as being configured to match the signal processing circuit 222, the impedance matching circuit 224 may be configured as a circuit include any suitable electrical components configured to maintain the input impedance (e.g., Z3) that matches the input impedance of the signal processing circuit (e.g., Z1). Accordingly, and in some implementations, the impedance matching circuit 224 may be implemented as input stage configured to minimize at least one or power consumption or a substrate layout footprint of the signal processing system 200, among other examples, while maintaining the input impedance (e.g., Z3) that matches the input impedance of the signal processing circuit (e.g., Z1).

Accordingly, and in some implementations, the input signals received at the first input terminal 212 may be proportional to the photon flux of the detected photons, may be proportional to the photon flux of the detected photons with the noise signals superimposed, or may correspond to the noise signals. Although the input signals received at the first input terminal 212 may be proportional to the photon flux of the detected photons, may be proportional to the photon flux of the detected photons with the noise signals superimposed, or may correspond to the noise signals, the differential TIA 220 may be configured to convert frequency components of input signals that are proportional to the photon flux of the detected events in the first bandwidth to converted signals (e.g., voltage signals) while rejecting the first frequency components and the second frequency components of the noise signals in the first bandwidth.

For example, the differential TIA 220 may be configured to convert the current signal I_{sensor_first} into a voltage signal via negative feedback resistors (e.g., shown as negative feedback resistors 220a in Fig. 2). Accordingly, and in some implementations, a differential voltage output by the differential TIA 220 may be based on a current value of the current signal L_{sensor_first} times resistance values of the negative feedback resistors 220a. In some implementations, the second differential input of the differential TIA 220 may not contribute to the differential voltage output of the differential TIA 220 (e.g., because the second differential input terminal of the differential TIA 220 is coupled to the second input terminal 214).

Accordingly, and in some implementations, a differential (e.g., a fully differential or substantially differential) and symmetrical, or substantially symmetrical, configuration may may be configured to provide the input signals to the differential TIA 220 as referenced to the second ground 208a, rendering any noise signals (e.g., ground bounce) generated (e.g., in association with processing performed by the IC 102) negligible in the differential output signals provided by the differential TIA 220.

In some implementations, the differential TIA 220 may be configured to provide the voltage signals to the pre-amplifier 226. The pre-amplifier 226 may be configured to convert the voltage signals to converted voltage signals (e.g., the pre-amplifier may be configured to amplify the voltage signals to generate amplified voltage signals) and provide the converted voltage signals to the comparator 228. Although the signal processing system 200 is shown and described as including the differential TIA 220 and the pre-amplifier 226 (e.g., as part of a front-end amplification chain), the pre-amplifier 226 may be an optional component. For example, rather than being configured to provide the voltage signals to the pre-amplifier 226 for processing, the differential TIA 220 may be configured to provide the voltage signals to the comparator 228 for processing.

In some implementations, the comparator 228 may be configured to detect, based on the converted voltage signals, occurrences of the detected photon events, such as by comparing the converted voltage signals to a threshold (e.g., one or more thresholds). In some implementations, the comparator 228 may include a time-to-digital converter (TDC) configured to generate time stamps corresponding to times of the occurrences of the detected photon events.

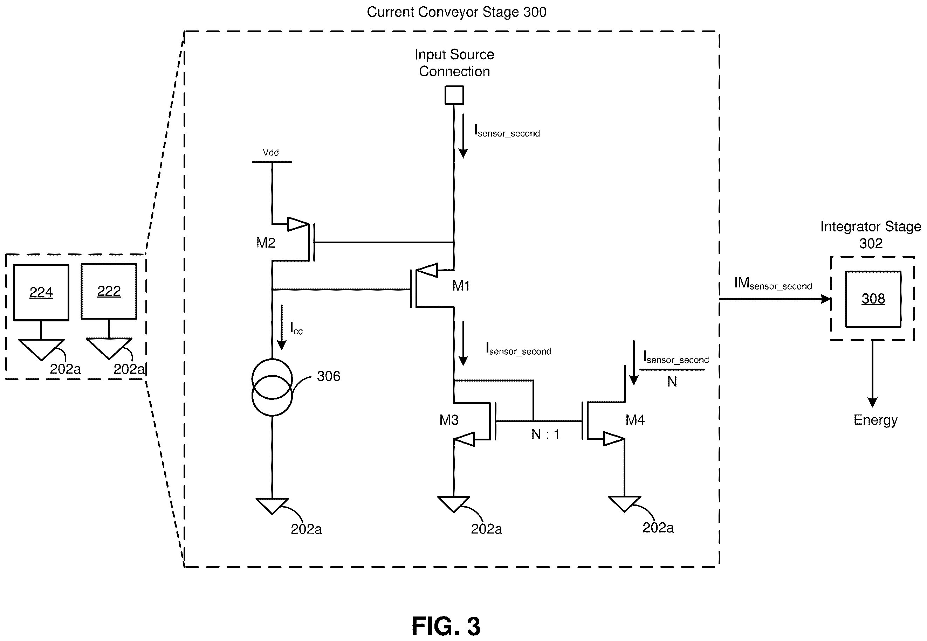

In some implementations, the signal processing circuit 222 may include a current conveyor stage (e.g., including one or more current conveyor circuits) and/or an integrator stage (e.g., including one or more integrator circuits) configured to detect, based on the frequency components of the input signals in the second bandwidth, energy values corresponding to the detected photon events, as described in more detail elsewhere herein. Fig. 3 is a diagram of an example current conveyor stage 300 and an example integrator stage 302 of the signal processing circuit 222, as described herein.

For example, the signal processing circuit 222 may include a current conveyor stage 300 including a current conveyor circuit and an integrator stage 302 including an integrator circuit. As shown in Fig. 3, the current conveyor circuit may include a first transistor M1, a second transistor M2, a third transistor M3, a fourth transistor M4, and an active load source 306 and the integrator circuit may include an integrator 308.

In some implementations, the first transistor M1 may be a current-conveying transistor. The second transistor M2 may be configured to regulate the first transistor M1. The active load source 306 may be configured to generate a current I_{CC} in idle conditions. The third transistor M3 may be configured to receive the current signal I_{sensor_second} (e.g., which may be forwarded to the third transistor M3). The third transistor M3 may be configured to mirror the current signal I_{sensor_second} to the fourth transistor M4, such as with a predefined gain ratio of N:1, among other examples. In some implementations, the first transistor M1, the third transistor M3, and the fourth transistor M4 may be configured to modulate the current signal I_{sensor_second}, optimizing a value of the current signal I_{sensor_second} for processing in the integrator stage 302, such as by attenuating the current signal I_{sensor_second} by a factor of N, among other examples.

Although the energy evaluation circuitry is described as including current conveyor stage 300, the energy valuation circuitry may be implemented in any suitable manner, such as by using a TIA. Additionally, or alternatively, the impedance matching circuit 224 may include the current conveyor stage 300 and/or the integrator stage 302 and the impedance matching circuit 224 may be configured to use the current conveyor stage 300 and/or the integrator stage 302 to maintain the input impedance Z3 that matches the input impedance of the signal processing circuit 222, Z1.

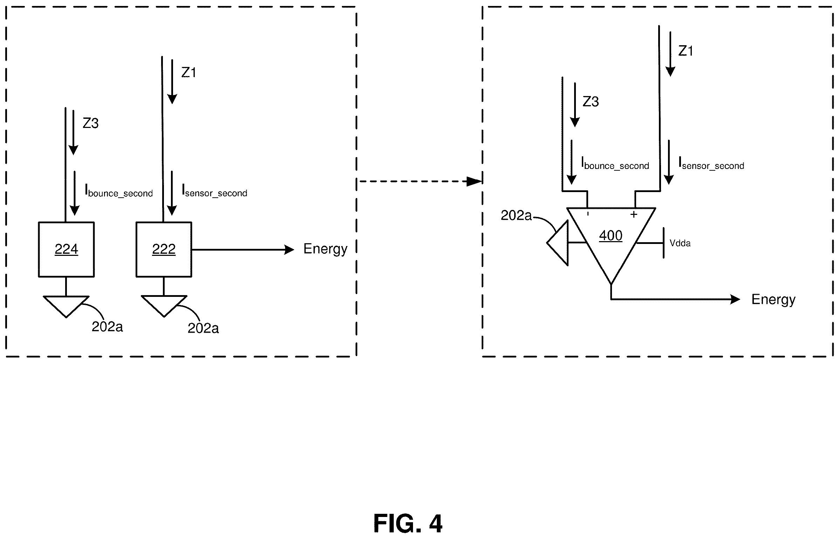

In some implementations, the signal processing circuit 222 and the impedance matching circuit 224 may be implemented as a differential current conveyor circuit, such as an example differential current conveyor circuit 400 shown and described in connection with Fig. 4. As shown in Fig. 4, the differential current conveyor circuit 400 may include a first differential input terminal (e.g., shown as a non-inverting input terminal) and a second differential input terminal (e.g., shown as an inverting input terminal).

The first differential input terminal may be configured to receive the current signal I_{sensor_second} (e.g., including the second frequency components of the input signals in the second bandwidth as described in connection with Fig. 2 and/or in more detail elsewhere herein) and the second differential input terminal may be configured to receive the current signal I_{bounce_second} (e.g., including the second frequency components of the input signals in the second bandwidth as described in connection with Fig. 2 and/or in more detail elsewhere herein). Accordingly, and in some implementations, the differential current conveyor circuit 400 may be used to extract the frequency components of the input signals in the second bandwidth while maintaining a matched input impedance toward the first differential input terminal of the differential TIA 220 (e.g., Z2) and the second differential input terminal of the differential TIA 220 (e.g., Z4). In this way, the symmetry and frequency response related to the differential TIA 220 may be maintained while reducing a number of components utilized by the signal processing system 200.

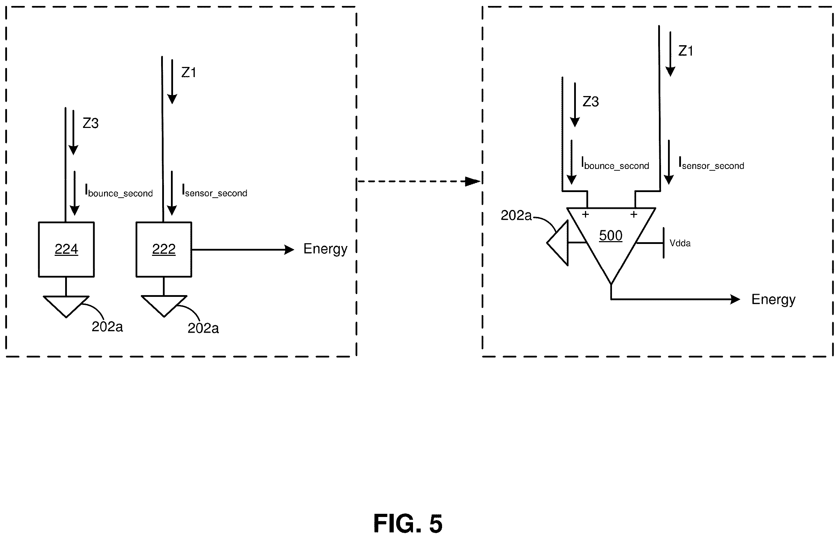

In some implementations, the signal processing circuit 222 and the impedance matching circuit 224 may be implemented as an additive current conveyor circuit, such as an example additive current conveyor circuit 500 shown and described in connection with Fig. 5. As shown in Fig. 5, the additive current conveyor circuit 500 may include a first additive input terminal (e.g., shown as a first non-inverting input terminal) and a second additive input terminal (e.g., shown as a second non-inverting input terminal).

The first additive input terminal may be configured to receive the current signal I_{sensor_second} (e.g., including the second frequency components of the input signals in the second bandwidth as described in connection with Fig. 2 and/or in more detail elsewhere herein) and the second additive input terminal may be configured to receive the current signal I_{bounce_second} (e.g., including the second frequency components of the input signals in the second bandwidth as described in connection with Fig. 2 and/or in more detail elsewhere herein). Accordingly, and in some implementations, the additive current conveyor circuit 500 may be used to extract the frequency components of the input signals in the second bandwidth while maintaining a matched input impedance toward the first differential input terminal of the differential TIA 220 (e.g., Z2) and the second differential input terminal of the differential TIA 220 (e.g., Z4). In this way, the symmetry and frequency response related to the differential TIA 220 may be maintained while reducing a number of components utilized by the signal processing system 200.

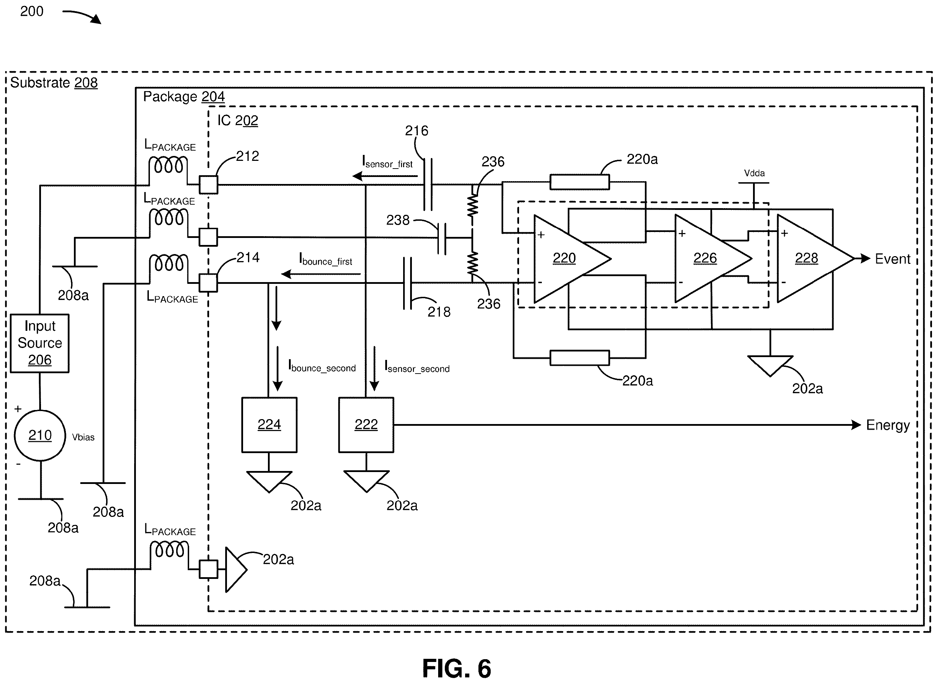

Fig. 6 is a diagram of an example signal processing system 600 as described herein. In some implementations, the signal processing system 600 may include the circuitry of the signal processing system 200 shown and described in connection with Fig. 2 and/or the circuitry shown and described in more detail elsewhere herein. In addition to including the circuitry of the signal processing system 200 of Fig. 2, and as shown in Fig. 6, the signal processing system 600 may include termination resistors 236 and a third AC-coupling capacitor 238 coupled between a node connecting the termination resistors 236 (e.g., a common node connecting the termination resistors 236).

In some implementations, the termination resistors 236 and the third AC-coupling capacitor 238 may be configured to reduce reflections and provide an AC ground (e.g., to aid in impedance matching and signal integrity associated with frequency components in the first bandwidth, among other examples). For example, resistance values of the termination resistors 236 may be values that satisfy a threshold (e.g., the resistance values may be above a minimum value to prevent excessive signal attenuation, increased power dissipation, and/or unwanted loading effects, among other examples). As another example, a capacitance value of the third AC-coupling capacitor 238 may be a value that allows the third AC-coupling capacitor 238 to maintain a frequency response of the differential TIA 220 (e.g., without distorting or filtering the frequency components of the input signals in the first bandwidth, among other examples).

In this way, some implementations described herein enable an IC-based system to be used for signal detection and evaluation (e.g., comprehensive signal detection and evaluation in association with TOF-based systems and/or systems utilizing TOF principles, among other examples). For example, some implementations described herein may be configured to use a single IC (e.g., a single application specific IC (ASIC) interfaced with one or more input sources) to analyze (e.g., independently analyze) signals, such as to analyze electrical signals, received from multiple input sources, across multiple bandwidths, among other examples.

By consolidating these functions into a single IC, some implementations described herein enhance functionality while reducing complexities and overhead (e.g., associated with systems utilizing multiple discrete ICs). This integration also improves cost efficiency by minimizing component count, lowering manufacturing expenses, and simplifying assembly. Additionally, performance is optimized through reduced signal transmission delays, minimized latency, and improved processing speed. Eliminating inter-IC communication enhances power efficiency, while the compact single-IC design reduces substrate (e.g., PCB) footprint (e.g., which is beneficial for space-constrained application). Accordingly, some implementations described herein enable cost-effective, high-performance, and energy-efficient signal processing with enhanced reliability.

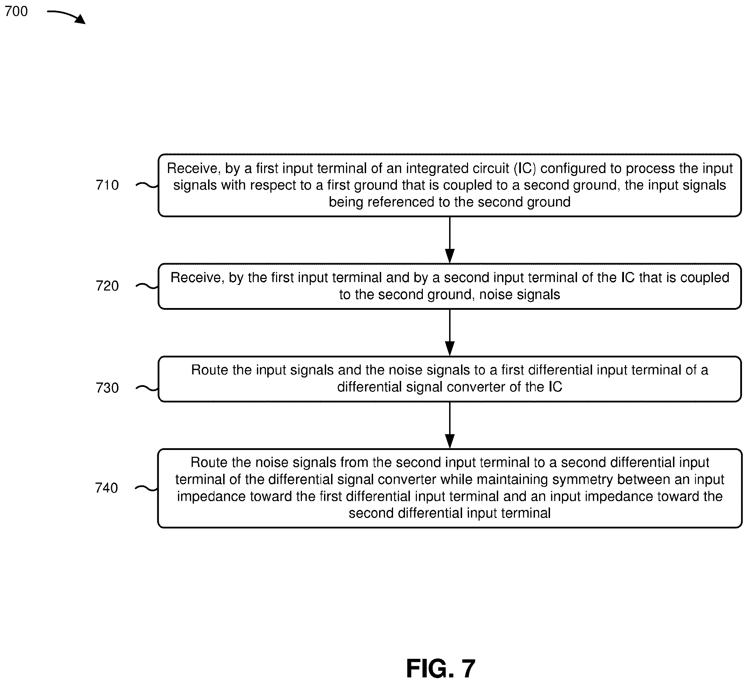

Fig. 7 is a flowchart of an example process 700 associated with optimized noise suppression for enhanced signal processing. In some implementations, one or more process blocks of Fig. 7 may be performed by an IC (e.g., the IC 102 and/or the IC 202). In some implementations, one or more process blocks of Fig. 7 may be performed by another device or a group of devices separate from or including the IC, such as a signal processing system (e.g., the signal processing system 200, and/or the signal processing system 600) and/or one or more components as shown and described in more detail elsewhere herein.

As shown in Fig. 7, the process 700 may include receiving, by a first input terminal of an IC configured to process the input signals with respect to a first ground that is coupled to a second ground, the input signals being referenced to the second ground (block 710). For example, the IC may be configured to receive and process the input signals with respect to a first ground that is coupled to a second ground. The IC may be configured to receive, by a first input terminal of the IC, input signals which are referenced to the second ground, as described in more detail elsewhere herein. In some implementations, the input signals may be proportional to physical quantities associated with detected events.

As further shown in Fig. 7, the process 700 may include receiving, by the first input terminal and by a second input terminal of the IC that is coupled to the second ground, noise signals (block 720). For example, the IC may be configured to receive, by the first input terminal and by a second input terminal of the IC that is coupled to the second ground, noise signals, as described in more detail elsewhere herein. In some implementations, the noise signals may be generated based on differences in potentials between the first ground and the second ground, as described in more detail elsewhere herein.

As further shown in Fig. 7, the process 700 may include routing the input signals and the noise signals to a first differential input terminal of a differential signal converter of the IC (block 730). For example, the IC may be configured to route the input signals and the noise signals to a first differential input terminal of a differential signal converter of the IC, as described in more detail elsewhere herein.

As further shown in Fig. 7, the process 700 may include routing the noise signals from the second input terminal to a second differential input terminal of the differential signal converter while maintaining symmetry between an input impedance toward the first differential input terminal and an input impedance toward the second differential input terminal (block 740). For example, the IC may be configured to route the noise signals from the second input terminal to a second differential input terminal of the differential signal converter while maintaining symmetry between an input impedance toward the first differential input terminal and an input impedance toward the second differential input terminal, as described in more detail elsewhere herein.

In some implementations, the IC may be configured to pass frequency components of the input signals and first frequency components of the noise signals in a first bandwidth to the first differential input terminal, pass second frequency components of the noise signals in the first bandwidth to the second differential input terminal, and/or extract frequency components from the input signals in a second bandwidth associated with frequencies that are lower than frequencies associated with the first bandwidth while maintaining the symmetry between the input impedance toward the first differential input terminal and the input impedance toward the second differential input terminal.

In some implementations, the differential signal converter may be further configured to convert the frequency components of the input signals in the first bandwidth into converted signals and suppress the noise signals by rejecting the first frequency components of the noise signals and the second frequency components of the noise signals in the first bandwidth.

Although Fig. 7 shows example blocks of the process 700, in some implementations, the process 700 may include additional blocks, fewer blocks, different blocks, or differently arranged blocks than those depicted in Fig. 7. Additionally, or alternatively, two or more of the blocks of the process 700 may be performed in parallel. The process 700 is an example of one process that may be performed by one or more devices described herein. These one or more devices may be configured to perform one or more other processes based on operations described herein, such as the operations described in connection with Figs. 1-6. Moreover, while the process 700 has been described in relation to the devices and components of the preceding figures, the process 700 can be performed using alternative, additional, or fewer devices and/or components. Thus, the process 700 is not limited to being performed with the example devices, components, hardware, and software explicitly enumerated in the preceding figures.

The foregoing disclosure provides illustration and description, but is not intended to be exhaustive or to limit the implementations to the precise forms disclosed. Modifications may be made in light of the above disclosure or may be acquired from practice of the implementations.

Additionally, the functionality of the elements described herein may be implemented using circuitry or processing circuitry, including general-purpose processors, special-purpose processors, ICs, ASICs, conventional circuitry, or combinations thereof, configured or programmed to perform the disclosed functionality. A processor is a type of processing circuitry, as it includes transistors and other physical circuit components. A processor may execute instructions stored in a memory, thereby operating as a programmed processor. In this disclosure, the terms "circuitry," "units," or "means" refer to hardware that performs, or is programmed to perform, the described functionality. Such hardware may include any disclosed hardware or other known hardware that is configured or programmed to execute the described functions. When the hardware includes a processor, which is a type of circuitry, the circuitry, means, or units refer to a combination of hardware and software, where the software configures the hardware and/or processor to perform the specified functions.

As used herein, matching an impedance, may, depending on the context, refer to at least one of matching, substantially matching, or approximating an impedance, such as to an extent that minimizes signal reflection, attenuation, and/or distortion. In some implementations, impedance matching may allow for deviations, such as slight deviations, while maintaining overall system efficiency and performance.

As used herein, maintaining symmetry may refer to at least one of maintaining, substantially maintaining, or approximating symmetry, such as to an extent that preserves an intended balance and/or attributes of a system. In some implementations, minor deviations may exist but remain within an acceptable tolerance range. For example, maintaining symmetry between an input impedance toward a first differential input terminal and a second differential input terminal may refer to at least one of maintaining, substantially maintaining, or approximating symmetry between the input impedance toward the first differential input terminal and the second differential input terminal, such as to an extent that preserves the balance and performance of a differential circuit utilizing the first differential input terminal and the second differential input terminal. In some implementations, minor impedance variations may be present, such as due to design constraints, component tolerances, and/or process variations, but such variations may remain within acceptable limits to ensure proper differential signal processing and noise rejection, among other examples.

As used herein, maintaining a same or similar frequency response (e.g., of a differential signal converter, among other examples) may refer to at least one of maintaining, substantially maintaining, or approximating a frequency response, such as to an extent that preserves an intended signal integrity, balance, and/or performance of the differential signal converter. In some implementations, variations in frequency response may occur, such as due to component tolerances, circuit layout constraints, and/or or operational conditions, but such variations remain within acceptable limits to ensure proper differential signal conversion. For example, the frequency response related to the differential TIA 220 (and/or any other differential circuitry as described in more detail elsewhere herein) may be at least one of maintained, substantially maintained, or approximated for signal amplification and noise rejection across an operating bandwidth, of the differential TIA 220, among other examples.

As used herein rejecting noise (e.g., noise signals, frequency components of noise signals, ground bounce signals, and/or frequency components of ground bounce signals, among other examples) may refer to at least one of rejecting, substantially rejecting, mitigating, or substantially mitigating noise signals, such as to reduce effects of the noise signals on circuit operation and/or system operation. In some implementations, noise rejections may be associated with differential signaling, filtering, shielding, and/or other techniques for minimizing interference while preserving an integrity of desired signals, among other examples.

As used herein, suppressing noise signals, may refer to at least one of suppressing, substantially suppressing, attenuating, or substantially attenuating noise signals (e.g., noise signals, frequency components of noise signals, ground bounce signals, and/or frequency components of ground bounce signals, among other examples) such as to reduce effects of the noise signals on circuit operation and/or system operation (e.g., as described in more detail elsewhere herein). In some implementations, suppression may be associated with active or passive techniques to reduce noise, such as within a defined frequency range or amplitude threshold, among other examples.

As used herein, passing frequency components (e.g., passing frequency components of input signals, first frequency components of noise signals, and/or second frequency components of noise signals in a first bandwidth) may refer to at least one of passing, substantially passing, transmitting, or substantially transmitting selected frequency components of a signal while attenuating or minimizing unwanted components. In some implementations, passing frequency components may be associated with filtering techniques that allow desired frequency ranges to propagate through a circuit while reducing interference or noise outside the intended bandwidth, among other examples.

As used herein, extracting frequency components, may refer to at least one of extracting, substantially extracting, or approximating an extraction of frequency components of a signal. In some implementations, extraction may include isolating relevant frequency bandwidths while attenuating or disregarding unwanted components.

As used herein, signals proportional to physical quantities (e.g., current signals proportional to a photon flux of detected photons, among other examples) may refer to at least one of signals that are proportional, substantially proportional, or otherwise correlated to a physical quantity in a way that allows meaningful extraction of information. In some implementations, proportionality may account for scaling factors, nonlinearities, and/or system-specific transformations, among other examples.

As used herein, a first ground may refer to a ground configured to serve as a reference for processing signals within a system. For example, an IC (e.g., the IC 102 and/or the IC 202) may be configured to use the first ground as a reference for processing input signals, as described in more detail elsewhere herein. In other words, the IC may be configured to process the input signals with respect to the first ground.

As used herein, a second ground may refer to a ground configured to serve as a reference for signals that are processed with respect to the first ground. For example, the second ground may be coupled to an input source configured to generate input signals referenced to the second ground. The input source may be configured to provide the input signals, referenced to the second ground, to the IC (e.g., the IC 102 and/or the IC 202) for processing with respect to the first ground.

Accordingly, and for example, the first ground may refer to an internal ground within an IC (e.g., the IC 102 and/or the IC 202) that is configured to serve as a reference for processing the input signals. The second ground may refer to an external ground (e.g., located externally to the IC, such as on a substrate and/or a PCB, among other examples) that is configured to serve as a reference for the input signals, which may be processed by the IC with respect to the first ground.

As used herein, satisfying a threshold may, depending on the context, refer to a value being greater than the threshold, greater than or equal to the threshold, less than the threshold, less than or equal to the threshold, equal to the threshold, not equal to the threshold, or the like.

Even though particular combinations of features are recited in the claims and/or described in this disclosure, these combinations are not intended to limit the disclosure of various implementations. In fact, many of these features may be combined in ways not specifically recited in the claims and/or described in this disclosure. Although each dependent claim listed below may directly depend on only one claim, the disclosure of various implementations includes each dependent claim in combination with every other claim in the claim set.

When an element is referred to herein as being "connected" or "coupled" to another element, it should be understood that the elements can be directly connected to the other element or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

As used herein, a phrase referring to "at least one of" a list of items refers to any combination and permutation of those items, including single members (e.g., an individual item in the list of items). As an example, "at least one of: a, b, or c" is intended to cover a, b, c, a-b, a-c, b-c, and a-b-c, as well as any combination with multiple of the same item. As used herein, the term "and/or" used to connect items in a list refers to any combination and any permutation of those items, including single members (e.g., an individual item in the list of items). As an example, "a, b, and/or c" is intended to cover a, b, c, a-b, a-c, b-c, and a-b-c.

No element, act, or instruction described herein should be construed as critical or essential unless explicitly described as such. Also, as used herein, the articles "a" and "an" are intended to include one or more items and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, or a combination of related and unrelated items), and may be used interchangeably with "one or more." Where only one item is intended, the phrase "only one" or similar language is used herein. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of").

In the preceding specification, various example embodiments have been described with reference to the accompanying drawings. It will, however, be evident that various modifications and changes may be made thereto, and additional embodiments may be implemented, without departing from the broader scope of the invention as set forth in the claims that follow. The specification and drawings are accordingly to be regarded in an illustrative rather than restrictive sense.

## Claims

1. An integrated circuit, comprising:
a first ground coupled to a second ground;
a first input terminal configured to:
receive input signals referenced to the second ground, and
receive noise signals coupled through the second ground,
wherein the integrated circuit is configured to process the input signals
and the noise signals with respect to the first ground;
a second input terminal, coupled to the second ground, configured to receive the noise signals coupled through the second ground;
a differential signal converter including a first differential input terminal and a second differential input terminal; and
circuitry configured to:
route the input signals and the noise signals from the first input terminal to the first differential input terminal; and
route the noise signals from the second input terminal to the second differential input terminal while maintaining symmetry between an input impedance toward the first differential input terminal and an input impedance toward the second differential input terminal.

2. The integrated circuit of claim 1, wherein
the differential signal converter is configured to convert the input signals into converted signals and suppress the noise signals via common-mode rejection.

3. The integrated circuit of claim 2, wherein
the circuitry is further configured to detect, based on the converted signals, measurement values corresponding to physical quantities associated with detected events.

4. The integrated circuit of claim 2 or 3, wherein
the circuitry is further configured to evaluate the converted signals and the integrated circuit is implemented as a single integrated circuit.

5. The integrated circuit of any one of the claims 1 to 4, wherein
the circuitry is further configured to:
pass frequency components of the input signals and first frequency components of the noise signals in a first bandwidth from the first input terminal to the first differential input terminal;
pass second frequency components of the noise signals in the first bandwidth from the second input terminal to the second differential input terminal; and
extract frequency components from the input signals in a second bandwidth associated with frequencies that are lower than frequencies associated with the first bandwidth while maintaining the symmetry between the input impedance toward the first differential input terminal and the input impedance toward the second differential input terminal.

6. The integrated circuit of claim 5, wherein the differential signal converter is configured to:
convert the frequency components of the input signals in the first bandwidth into converted signals; and
suppress the noise signals by rejecting the first frequency components of the noise signals and the second frequency components of the noise signals in the first bandwidth.

7. The integrated circuit of claim 5 or 6, wherein
the first bandwidth corresponds to frequencies associated with a first signal information type and the second bandwidth corresponds to frequencies associated with a second signal information type.

8. The integrated circuit of any one of the claims 1 to 7, wherein
the input signals are received from different input sources.

9. The integrated circuit of any one of the claims 1 to 8, wherein the circuitry is further configured to:
produce currents inducing differences in potentials between the first ground and the second ground resulting in generation of the noise signals.

10. The integrated circuit of any one of the claims 1 to 9, wherein
the second ground is included in a substrate which is coupled to the integrated circuit and to an input source associated with generating the input signals;
and/or wherein
the circuitry includes a first coupling element configured to alternating current (AC)-couple the first differential input terminal to the first input terminal and a second coupling element configured to AC-couple the second differential input terminal to the second input terminal.

11. The integrated circuit of any one of the claims 1 to 10, wherein the input signals are at least one of:
reflected laser pulses, associated with a light detection and ranging system, corresponding to detected reflections from a target object,
electrical signals, associated with a time-of-flight positron emission tomography system, corresponding to detected gamma photons,
fluorescence signals, associated with a flow cytometry system, corresponding to light emitted by fluorescently-labeled particles,
radiation signals, associated with a radiation detection system, corresponding to detected radiation events from a radioactive source,
X-ray photon signals, associated with a -time-of-flight-computed tomography system, corresponding to detected X-ray photons,
biological signals, associated with a life sciences signal processing system, corresponding to at least one of emitted fluorescence or light scattering from biological samples, or
electrical signals, associated with a power system, corresponding to detected changes in at least one of a voltage or a current associated with the power system.

12. The integrated circuit of any one of the claims 1 to 11, wherein
the input signals are current signals corresponding to a photon flux of detected photon events and the differential signal converter is a transimpedance amplifier configured to convert the current signals into voltage signals.

13. The integrated circuit of claim 12, wherein the circuitry is further configured to:
detect, based on the voltage signals, occurrences of the detected photon events by comparing the voltage signals to a threshold; and
generate time stamps corresponding to times of the occurrences of the detected photon events
and/or
wherein the circuitry further configured to:
extract frequency components from the current signals in a bandwidth related to frequencies corresponding to energy information associated with the detected photon events; and
determine, based on the frequency components of the current signals in the bandwidth related to the frequencies corresponding to the energy information, energy measurement values indicative of energies associated with the detected photon events.

14. A system, comprising:
an input source configured to generate input signals; and
an integrated circuit as set forth in any one of the preceding claims, the integrated circuit being configured to process the input signals with respect to a first ground,
wherein the input signals are referenced to a second ground that is coupled to the first ground.

15. A method, comprising:
receiving input signals, by a first input terminal of an integrated circuit configured to process the input signals with respect to a first ground that is coupled to a second ground,
wherein the input signals are referenced to the second ground that is coupled to the first ground;
receiving, by the first input terminal and by a second input terminal of the integrated circuit that is coupled to the second ground, noise signals;
routing the input signals and the noise signals to a first differential input terminal of a differential signal converter of the integrated circuit; and
routing the noise signals from the second input terminal to a second differential input terminal of the differential signal converter while maintaining symmetry between an input impedance toward the first differential input terminal and an input impedance toward the second differential input terminal.
